Europäisches Patentamt

European Patent Office

Office européen des brevets

(19)

(11) **EP 0 560 711 B1**

(12) **EUROPÄISCHE PATENTSCHRIFT**

(45) Veröffentlichungstag und Bekanntmachung des Hinweises auf die Patenterteilung:
**03.01.1996 Patentblatt 1996/01**

(51) Int. Cl.$^6$: **B23K 11/25**, H03K 3/57, H02M 3/155

(21) Anmeldenummer: **93810118.5**

(22) Anmeldetag: **22.02.1993**

(54) **Elektrische Speiseschaltung zur Erzeugung von einzeln steuerbaren Stromimpulsen**

Electric supply circuit for the generation of separately controllable current pulses

Circuit électrique d'alimentation pour la génération d'impulsions de courant contrôlables séparément

(84) Benannte Vertragsstaaten:
**AT CH DE FR IT LI NL**

(30) Priorität: **09.03.1992 CH 742/92**

(43) Veröffentlichungstag der Anmeldung:
**15.09.1993 Patentblatt 1993/37**

(73) Patentinhaber: **Breitmeier, Max**
**CH-8115 Hüttikon (CH)**

(72) Erfinder: **Breitmeier, Max**
**CH-8115 Hüttikon (CH)**

(74) Vertreter: **OK pat AG**
**CH-6330 Cham (CH)**

(56) Entgegenhaltungen:
**FR-A- 2 095 113       FR-A- 2 264 431**
**US-A- 4 734 556       US-A- 4 973 815**

## Beschreibung

Die Erfindung betrifft eine elektrische Speiseschaltung zur Erzeugung von einzeln steuerbaren Stromimpulsen, insbesondere für die Widerstandsschweissung, mit einem Transformator, auf dessen Primärseite ein mit Gleichstrom gespeister, gesteuert auf- und entladbarer Speicherkondensator vorhanden ist und dessen Sekundärkreis die Last enthält.

Für verschiedene Anwendungen, z.B. in der Widerstands-Schweisstechnik, werden Stromimpulse von kurzer Dauer und hoher Stromstärke benötigt. Zwischen den einzelnen Impulsen bestehen stromlose Pausen von relativ langer Dauer, d.h. der Effektivwert des Impulses beträgt ein Vielfaches des Effektivwertes über die gesamte Taktzeit (Dauer von Impuls und anschliessender Pause).

Impulsweiser Strombezug dieser Art hat merkliche oder gar unzulässige Auswirkungen auf das speisende Netz. Die Stromimpulse werden in der Regel nur einphasig benötigt; wenn sie mit einem üblichen, einphasigen Transformator übertragen werden, so wird auch nur eine Phase des Netzes belastet. Abgesehen von den störenden Rückwirkungen in der belasteten Phase werden dann zusätzlich noch unerwünschte Asymmetrien im mehrphasigen Netz erzeugt.

Um unerwünschte Rückwirkungen auf das speisende Netz möglichst gering zu halten, ist es einerseits bekannt, die Impulsenergie aus Kondensatoren zu beziehen, die während den Impulspausen geladen und dann stossartig entladen werden. Da hierbei die Ladezeit jeweils ein Vielfaches der Entladezeit beträgt, sind die das Netz belastenden, durch Gleichrichtung erzeugten Ladegleichströme entsprechend kleiner als die Impulsströme und der Strombezug aus dem Netz ist entsprechend zeitlich ausgeglichen. Wird der Ladegleichstrom durch eine dreiphasige Gleichrichterschaltung zeugt, so werden die Phasenströme im speisenden Netz weiter reduziert und ausserdem die Phasen symmetrisch belastet. - Bei der genannten Schaltung ist der Scheitelwert des Entladestromes direkt von der erreichten Ladespannung des Kondensators abhängig. Indem die Ladespannung jeweils auf einen vorgegebenen Wert begrenzt wird, ist es somit auf einfache Weise möglich, den Energieinhalt der Einzelimpulse zu steuern. Indessen war bis anhin der Anwendungsbereich dieses Schaltungsprinzips stark eingeschränkt, weil die Entladung, einmal ausgelöst, in ihrem zeitlichen Ablauf kaum mehr beeinflusst werden kann; die Impulsform ist deshalb praktisch durch die Eigenschaften der Entladeseite, insbesondere des Lastkreises, gegeben bzw. festgelegt. Auch bei Verwendung eines steuerbaren Halbleiters im Entladekreis lässt sich höchstens die Geschwindigkeit des Impuls-Stromanstiegs und -Stromabfalls beschränkt beeinflussen, wobei eine solche Einwirkung immer mit Energieverlusten im Steuerelement einhergeht.

Für manche Anwendungen ist es aber erforderlich, die Form der Einzelimpulse, d.h. den zeitlichen Stromverlauf über die Impulsdauer, weitergehend zu beeinflussen. Für solche Fälle ist die Impulserzeugung mit Hilfe von sogenannten Inverterschaltungen bekannt. Bei diesen wird die Netzwechselspannung (mehrphasig) zunächst gleichgerichtet und die erzeugte Gleichspannung mittels einer Transistor-Brückenschaltung mit höherer Frequenz zerhackt. Der so erzeugte mittelfrequente Wechselstrom wird dann über einen Schweisstransformator übertragen und im Lastkreis mittels Leistungsdioden gleichgerichtet. Die Steuerung der Schweissimpulse erfolgt auf der Primärseite des Transformators. Es werden also im Takt der Mittelfrequenz gesteuerte, gleichgerichtete Einzelimpulse erzeugt, die aneinandergereiht den zeitlichen Stromverlauf im Lastkreis bestimmen. Damit lassen sich zwar höhere Anforderungen hinsichtlich zeitlicher Steuerung bzw. "Formgebung" von Stromimpulsen grundsätzlich erfüllen. Es bleiben aber die Nachteile des impulsweisen Energiebezuges bestehen, indem der Grundtakt der Schweisstrom-Impulse erhalten bleibt, d.h. die impulsweise Belastung voll auf das Speisenetz zurückwirkt. Weitere Nachteile sind die Verwendung von Hochstrom-Dioden im Lastkreis sowie (jedenfalls für manche Anwendungen in der Schweisstechnik) der Umstand, dass die so erzeugten Stromimpulse immer gleichgerichtete Impulse sind.

Mit der vorliegenden Erfindung soll eine Speiseschaltung der eingangs genannten Gattung vorgeschlagen werden, die die erwähnten Vorteile des Kondensator-Lade- und -Entladekreises beibehält, aber auch, mit Regeleinwirkung auf der Primärseite des Transformators, eine weitgehende Beeinflussung und Programmierung der Impulsformen sowie die Regelung der Impulsenergie gestattet.

Die Speiseschaltung gemäss der Erfindung, mit der diese Aufgabe gelöst wird, ist gekennzeichnet durch zwei zwischen den Speicherkondensator und den Transformator geschaltete Hilfskondensatoren gleicher Kapazität, die über je ein Ladesteuerorgan mit dem Speicherkondensator und über je ein Entladesteuerorgan mit der Primärseite des Transformators verbunden sind, wobei die Kapazität des Speicherkondensators ein Vielfaches derjenigen der Hilfskondensatoren beträgt und wobei die letzteren mit der Induktivität des Entladekreises je einen Parallelschwingkreis bilden; ferner ist die erfindungsgemässe Schaltung gekennzeichnet durch Steuermittel, die mit den Lade- und den Entladesteuerorganen verbunden sind, um die beiden Hilfskondensatoren abwechselnd und taktweise kontrolliert zu laden und zu entladen und dadurch dichte Folgen von Teilimpulsen zu erzeugen, die, über den Transformator übertragen, jeweils zusammen einen der zu erzeugenden Stromimpulse bilden, wobei die Steuermittel so gestaltet sind, dass die von ihnen bestimmte Taktfrequenz der Teilimpulse der Eigenfrequenz der genannten Schwingkreise entspricht.

Die erfindungsgemässe Schaltung vereinigt in sich gewissermassen die Vorteile und technischen Möglichkeiten der Kondensator-Ladung und -Entladung mit denjenigen der Inverterschaltung: Indem für jeden zu erzeugenden Impuls die benötigte Energie jeweils im Speicherkondensator bereitgestellt wird und dieser während den zwischenliegenden Impulspausen aufgeladen wird, sind die eingangs erwähnten, durch stossweisen Energiebezug verursachten Netzrückwirkungen weitgehend gemildert, und die Anschlussleistung der Schaltung ist etwa entsprechend dem Impuls-Pause-Verhältnis reduziert. Anderseits aber kann dank Bemessung jedes einzelnen Teilimpulses die Impulsform (Hüllkurve) nach Bedarf gestaltet und programmiert werden; insbesondere sind die Einhaltung mehrerer Stromstufen oder auch "Einschnitte" mit Wiederanstieg der Stromstärke während der Impulsdauer möglich. Dabei entspricht die Anstiegs- und Abfallgeschwindigkeit derjenigen der Resonanzschwingung bei der Frequenz der Teilimpulse (üblicherweise ein Mehrfaches der Netzfrequenz), d.h. es können Impulsformen mit hoher Flankensteilheit erzielt werden. Schliesslich werden keine Leistungshalbleiter im Sekundärkreis benötigt, und je nach Schaltungsvariante können Gleichstromimpulse (aus Teilimpulsen gleichbleibender Polarität) oder aber Wechselstromimpulse (aus Teilimpulsen mit alternierender Polarität) erzeugt werden.

Besondere und vorteilhafte Ausführungsformen der im Anspruch 1 definierten Speiseschaltung sind in den Ansprüchen 2 bis 14 angegeben.

Nachfolgend wird die Erfindung anhand von Ausführungsbeispielen im Zusammenhang mit der Zeichnung näher erläutert.

Es zeigen:

Fig. 1  ein vereinfachtes Prinzipschaltbild einer ersten Variante der erfindungsgemässen Speiseschaltung,

Fig. 2  einen typischen zeitlichen Verlauf verschiedener Grössen in der Schaltung nach Fig. 1, und zwar

a) der Spannung $U_C$ am Speicherkondensator C,
b) der Spannungen $U_{C1}$ bzw. $U_{C2}$ an den beiden Hilfskondensatoren $C_1$ und $C_2$ (grösserer Spannungs-Massstab als für $U_C$ im Diagramm a), und
c) den Stromverlauf einer Folge von Teilimpulsen (gleichbleibende Scheitelwerte der Teilimpulse angenommen),

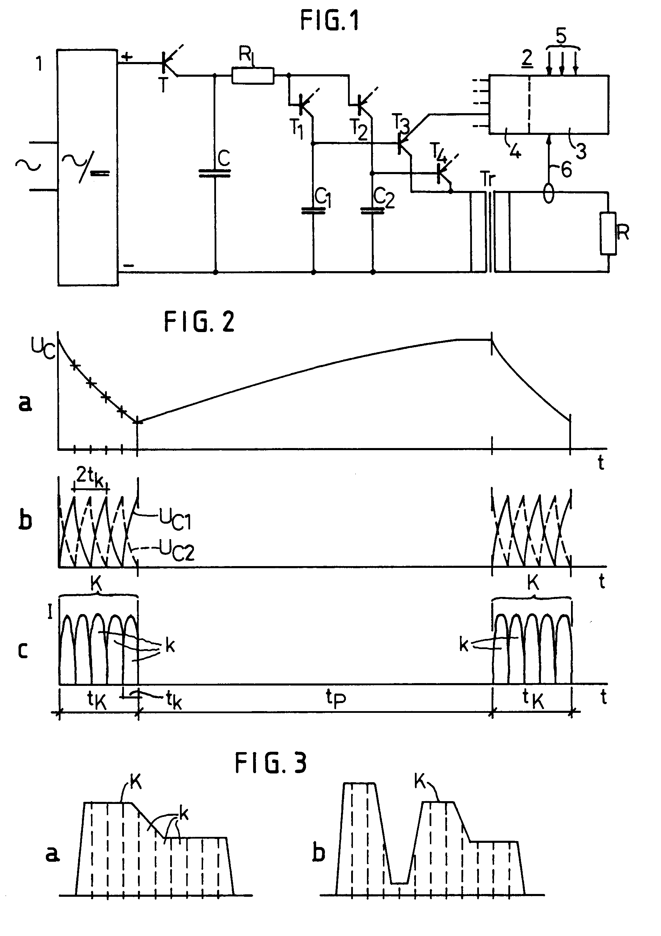

Fig. 3a und 3b  zwei Beispiele von Impulsformen (Hüllkurven), wie sie durch Bemessung der Teilimpulse gestaltet werden können,

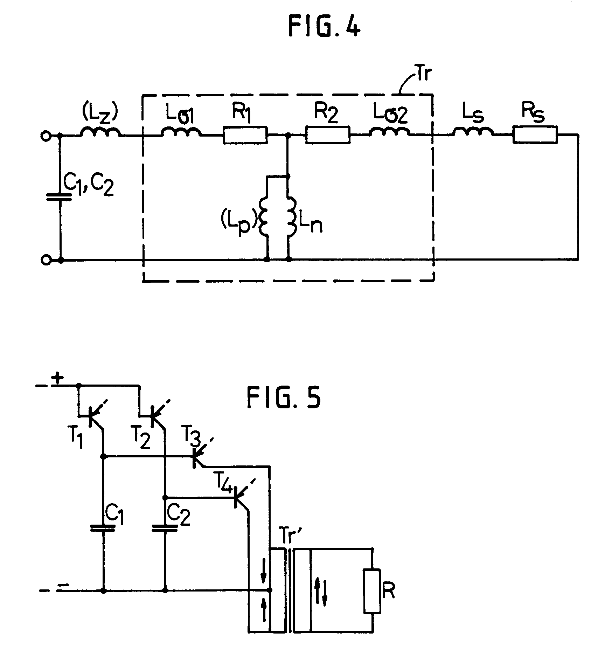

Fig. 4  ein Ersatzschaltbild des (gemeinsamen) Entladekreises der beiden Hilfskondensatoren, und

Fig. 5  das vereinfachte, teilweise Schaltbild einer Schaltungsvariante zur Erzeugung von Wechselstromimpulsen aus Teilimpulsen von alternierender Polarität.

Die Speiseschaltung nach Fig. 1 enthält eingangsseitig einen üblicherweise aus dem Wechselstromnetz gespeisten Gleichrichterteil 1. An dessen Gleichstrom-Ausgang ist ein Speicherkondensator C angeschlossen, der über ein geeignetes Steuerorgan, vorzugsweise einen Transistor T, kontrolliert aufladbar ist. Auf der Ausgangsseite enthält die Schaltung einen Transformator Tr, in dessen Sekundärkreis die als ohmscher Widerstand R dargestellte Last geschaltet ist. Beispielsweise handelt es sich um das "Fenster" mit den Schweisselektroden einer Widerstands-Schweissmaschine insbesondere für Punktschweissung, wobei die Last im wesentlichen durch die Schweissstrecke gebildet ist.

Die Speiseschaltung dient dazu, einzeln steuerbare Stromimpulse zu erzeugen, die über den Transformator Tr auf den Laststromkreis übertragen werden. Für die Impulserzeugung sind zwei Hilfskondensatoren $C_1$ und $C_2$ von gleicher Kapazität vorgesehen, die zwischen den Speicherkondensator C und den Transformator Tr geschaltet sind. Dabei beträgt die Kapazität des Speicherkondensators C ein Vielfaches der Kapazität der Hilfskondensatoren $C_1$ und $C_2$. Ueber einen gemeinsamen Ladewiderstand $R_1$ und je ein Ladesteuerorgan $T_1$ bzw. $T_2$ sind die Hilfskondensatoren mit dem Speicherkondensator verbunden, und ferner sind die Hilfskondensatoren über je ein Entladesteuerorgan $T_3$ bzw. $T_4$ an die Primärsteite des Transformators - im vorliegenden Fall an das gleiche Ende einer einfachen Primärwicklung - angeschlossen.

Das Laden der Hilfskondensatoren $C_1$ und $C_2$ aus dem Speicherkondensator C wie auch das Entladen der Hilfskondensatoren über den Transformator Tr erfolgt abwechseld und taktweise kontrolliert durch weiter unten näher beschriebene Steuermittel 2, mit denen, wie angedeutet, die Steuerelektroden der Steuerorgane $T_1$ bis $T_4$ verbunden sind. Auch das periodische Aufladen des Speicherkondensators C über den Transistor T ist in diese Steuerung einbezogen. Für die kontrollierte Ladung der Hilfskondensatoren sind als Ladesteuerorgane vorzugsweise Transistoren vorgesehen, wogegen als Entladesteuerorgane Thyristoren oder ebenfalls Transistoren verwendbar sind. Wie nachstehend anhand der Fig. 2 erläutert wird, entstehen durch das abwechselnde Laden und Entladen der beiden Hilfskondensatoren dichte Folgen von Teilimpulsen k, die über den Transformator Tr übertragen werden, wobei jeweils eine solche Folge von dicht aneinander anschliessenden Teilimpulsen k einen der zu erzeugenden Stromimpulse K bilden. Dabei ist von Bedeutung, dass jeder der Hilf-

skondensatoren $C_1$ und $C_2$ mit der Induktivität des Entladekreises einen Parallelschwingkreis bildet (Erläuterung weiter unten anhand Fig. 4), und dass die von den Steuermitteln 2 bestimmte Taktfrequenz $f_k$ der Teilimpulse k der Eigenfrequenz dieser Schwingkreise entspricht.

Beim Schaltungsbeispiel nach Fig. 1 und gemäss den entsprechenden Diagrammen nach Fig. 2 und 3 handelt es sich bei den Teilimpulsen k um solche gleicher Polarität, so dass die erzeugten, sekundärseitigen Stromimpulse K Gleichstromimpulse sind. In der Darstellung nach Fig. 2 sind der Einfachheit halber zunächst gleichbleibende Amplituden der Teilimpulse k zur Erzeugung von Gleichstrom-Rechteckimpulsen K angenommen.

Entsprechend dem Zeitdiagramm Fig. 2a wird der Speicherkondensator C, ausgehend vom geladenen Zustand, jeweils während der Dauer $t_K$ eines zu erzeugenden Stromimpulses schrittweise, im Takt der Teilimpulse, bis auf eine Restspannung entladen; der Ladestransistor T bleibt während diesem Vorgang gesperrt. Anschliessend, während der Impulspause $t_P$ zwischen zwei Stromimpulsen K, wird der Speicherkondensator bei geöffnetem Transistor T aus dem Gleichrichterteil 1 aufgeladen. Ladespannung und Kapazität des Speicherkondensators C müssen so bemessen sein, dass die gespeicherte Ladung jedenfalls für den jeweils nachfolgenden Stromimpuls K sicher ausreicht.

Zur Bildung einer Teilimpuls-Folge werden die Hilfskondensatoren $C_1$, $C_2$ abwechselnd durch taktweises und kontrolliertes Oeffnen der Transistoren $T_1$ bzw. $T_2$ aus dem Speicherkondensator auf eine vorbestimmte Spannung aufgeladen. Jeweils anschliessend, d.h. ebenfalls abwechselnd und im gleichen Takt durch entsprechende Steuerung von $T_3$ und $T_4$, entladen sich die Hilfskondensatoren über den Transformator Tr. Der betreffende Verlauf der Spannungen $U_{C1}$ und $U_{C2}$ jeweils während einer Folge von Teilimpulsen k geht aus Fig. 2b hervor. Das fortschreitende Absinken der Ladespannung am Speicherkondensator C nach Fig. 2a ergibt sich dabei aus der taktweisen Ladungsaufnahme und -Weitergabe über die beiden Hilfskondensatoren. Jede Entladung eines der Hilfskondensatoren über den Transformator erzeugt einen Teilimpuls k gemäss Fig. 2c, und eine Anzahl solcher aufeinanderfolgender Teilimpulse bildet den Stromimpuls K. Die Amplitude jedes Teilimpulses ist bestimmt durch die Ladespannung des ihn abgebenden Hilfskondensators und durch die Parameter des Entladestromkreises, gebildet durch den Transformator und die sekundärseitig daran angeschlossene Last. Die Dauer eines Stromimpulses K ist jeweils gegeben durch die Taktzeit $t_k$ und die Anzahl der Teilimpulse k. Durch Vorgabe der Anzahl Teilimpulse k an den Steuermitteln 2 kann somit (bei gegebener Taktfrequenz) die Länge der Stromimpulse K bequem eingestellt werden.

Durch kontrollierte Bemessung der Amplitude jedes einzelnen Teilimpulses k lässt sich die Gestalt (Hüllkurve) bzw. der zeitliche Verlauf der Stromimpulse K exakt bestimmen und auch programmieren. Dies geschieht zweckmässigerweise durch Vorgabe bzw. Programmierung und Messung des Höchstwertes der Ladespannung an den Hilfskondensatoren von den Steuermitteln 2 aus, was durch an sich bekannte, nicht näher dargestellte Schaltungsmittel möglich ist. Das abwechselnde Laden der Hilfskondensatoren $C_1$, $C_2$ über die Transistoren $T_1$, $T_2$ soll dabei so erfolgen, dass die maximal benötigte Ladedauer zur Erreichung der vorgegebenen Ladespannung der Hilfskondensatoren auch bei abnehmender Spannung am Speicherkondensator C immer etwas kürzer ist als die Taktzeit $t_k$ der Teilimpulse. Dies wird im wesentlichen mittels Steuerung des Wiederstandes der Ladetransistoren $T_1$, $T_2$ und gegebenenfalls durch Bemessung eines Ladewiderstandes $R_1$ erreicht.

Weil die Energie bzw. die Amplitude jedes Teilpulses durch Vorgabe der Ladespannung des betreffenden Hilfskondensators bestimmt wird, kommt es nicht auf den jeweiligen, variablen Wert der Spannung $U_C$ am Speicherkondensator an, es muss nur gewährleistet sein, dass $U_C$ jeweils zu Beginn einer Teilimpuls-Folge so hoch ist, dass die gesamte Energie des zu bildenden Stromimpulses im Speicherkondensator enthalten ist bzw. dass die Restspannung für den letzten Teilimpuls der Folge noch genügend hoch ist, um den Hilfskondensator in der Zeit $t_k$ ausreichend zu laden. Aus dem gleichen Grund wirken sich Spannungsschwankungen des Speisenetzes, aus dem der Speicherkondensator geladen wird, auf die Bildung der Teilimpulse und des Stromimpulses K nicht aus. Grundsätzlich könnte der Speicherkondensator auch dauernd mit dem Gleichrichterteil 1 direkt verbunden sein und dessen Ladesteuerung mittels Transistor T entfallen. Wesentlich ist anderseits, dass der Energiebezug aus dem Netz zeitlich ausgeglichen ist, d.h. dass der Effektivwert des Netzbelastungsstromes etwa entsprechend dem Impuls-Pause-Verhältnis $t_K/t_P$ (gegeben durch den Arbeitsprozess z.B. einer Punktschweissmaschine) gegenüber dem Effektivwert des Impulsstromes herabgesetzt wird.

Fig. 3a und 3b zeigen zwei Beispiele von programmierten Impulsformen K, wobei die Gesamtdauer des Impulses K durch die Anzahl Teilimpulse k der Impulsfolge und die Gestalt bzw. der zeitliche Verlauf des Stromimpulses K durch die Amplituden der aufeinanderfolgenden Teilimpulse k gegeben sind. Wie ersichtlich, können über die Impulsdauer ohne weiteres Stufen der Stromstärke und auch ein vorübergehender Stromabfall auf ein Zwischenminimum mit Wiederanstieg der Stromstärke vorgegeben werden.

Die Steuermittel 2 sind, wie in Fig. 1 schematisch angedeutet, zweckmässig in einen Eingabeteil 3 und einen Steuerteil 4 unterteilt. Von letzterem gehen insbesondere die Steuerleitungen für das taktweise Oeffnen und Schliessen der Steuerorgane T und $T_1$ bis $T_4$ aus. Am Eingabeteil 3 sind Eingangsleitungen 5 angedeutet für die Eingabe von Sollwerten wie Impulsdauer (Anzahl Teilimpulse) und Stromstärke, Startsignale für den Beginn der Stromimpulse usw. Selbstverständlich kann ein eigentlicher Programmteil angeschlossen oder im Eingabeteil 3 integriert sein, insbesondere zur Programmierung der Stromimpulsform.

Vor allem zweckmässig ist auch die Erfassung der Sekundärstrom-Momentanwerte der Teilimpulse k, wie mit der Signalleitung 6 vom Sekundärkreis des Transformators Tr zum Eingabeteil 3 angedeutet ist. Innerhalb der Steuermittel 2 kann dann ein laufender Sollwert-/Istwertvergleich für den Sekundärstrom durchgeführt und daraus die selbstgeführte Regelung der Impulsstromstärke mittels Beeinflussung der Ladespannungen der Hilfskondensatoren abgeleitet werden.

Wie weiter oben bereits ausgeführt, soll die Frequenz der Teilimpulse $f_k = 1/2t_k$ der Eigenfrequenz des Schwingkreises entsprechen, der durch den jeweiligen Hilfskondensator und dessen Entladestromkreis gebildet wird. (Die Teilimpulse k der Dauer $t_k$ sind als Halbwellen aufzufassen, die - beim Beispiel nach Fig. 1 und 2 mit gleicher Polarität - abwechselnd aus einem der beiden Hilfskondensatoren stammen, somit beträgt die Periodendauer der Hilfskondensator-Entladung $2t_k$). Ferner gilt für die genannten Parallelschwingkreise die Beziehung

$$2\pi f_k = \omega = \sqrt{\frac{1}{LC} - \frac{R^2}{4L^2}},$$

wobei

C = Kapazität eines Hilfskondensators
L = Induktivität des Entladekreises
R = ohmscher Widerstand des Entladekreises

Einige massgebende Zusammenhänge bezüglich dieser Schwingkreise und der Wirkungsweise der Schaltung sollen nachstehend anhand des Ladekreis-Ersatzschaltbildes nach Fig. 4 näher betrachtet werden. Im Ersatzschaltbild sind die Elemente T₃ bzw. T₄ weggelassen, da deren Impedanz während der Entladung als Null angenommen werden kann. Es bedeuten:

$L_{\sigma 1}, L_{\sigma 2}$ = Primär- bzw. Sekundär-Streuinduktivität
$R_1, R_2$ = Primär- bzw. Sekundär-Wicklungswiderstand
$L_n$ = Hauptinduktivität des Transformators
$L_s$ = Induktivität der Sekundärschleife
$R_s$ = Last- und übrige Sekundärwiderstände
$L_z$ = (event.) Zusatzinduktivität primärseitig
$L_p$ = (event.) Parallelinduktivität

Die Schwingkreis-Eigenfrequenz kann durch Bemessung der Parameter des Entladekreises und des Uebersetzungsverhältnisses des Transformators gewählt werden. Sie wird zweckmässigerweise möglichst hoch (jedenfalls auf ein Mehrfaches der Speisenetzfrequenz) angesetzt, so dass die Dauer $t_k$ der Teilimpulse möglichst kurz ist. Daraus ergeben sich ein kleiner Impulstransformator Tr, steile Impulsflanken, geringere Restwelligkeit der Stromimpulse sowie die Möglichkeit vielfältiger, "feiner" Abstufungen bei der Gestaltung der Stromimpulsform. Wie leicht einzusehen ist, wird die maximale Aenderungsgeschwindigkeit der Stromstärke massgeblich durch die Steilheit der Teilimpulse und damit wiederum von der Schwingkreis-Eigenfrequenz bestimmt.

Zwecks Bemessung der gewünschten Eigenfrequenz kann die Kreisinduktivität L durch eine Parallelinduktivität $L_p$ verkleinert (z.B. Vergrösserung des Luftspaltes im Transformatorkern) oder bei Bedarf mittels einer zusätzlichen Serieinduktivität $L_z$ auch vergrössert werden.

Besonders zweckmässig ist es, die Schwingkreis-Parameter für gedämpfte, periodische Schwingungen auszulegen. Dies trifft bekanntlich dann zu, wenn $4L - R^2C < 0$ ist. Es löst dann jede Entladung eines der Hilfskondensatoren die erste Halbwelle einer solchen gedämpften Schwingung aus. Der Nulldurchgang am Ende jeder Halbwelle kann dann von der Steuerung festgestellt werden (angedeutet durch die Leitung 6 in Fig. 1), wodurch die taktweise Steuerung des Ladens und Entladens der Hilfskondensatoren selbstgeführt mit der Eigenfrequenz des Schwingkreises erfolgen kann. - Würde die Entladung in Form einer Schwingung im periodischen Grenzfall ($4L - R^2C = 0$) erfolgen, so müsste für die Selbstführung eine Schwellenspannung vorgegeben werden, deren Ueberschreiten durch den Momentanwert der Schwingung den gleichen Effekt wie der vorstehend beschriebene Nulldurchgang hätte.

Eine "interne" Regelung ausgehend von der Istwert-Erfassung im Sekündärkreis wird zweckmässig auch auf die Amplitude jedes Teilimpulses angewendet: Aufgrund der gemessenen Stromstärke jedes Teilimpulses wird durch die Steuermittel die Ladespannung des Hilfskondensators für den nächstfolgenden Teilimpuls festgelegt. Dadurch kann selbsttätig der Energiefluss konstant gehalten bzw. entsprechend einem programmierten Verlauf geführt werden, und zwar unbeeinflusst von Spannungsschwankungen des speisenden Netzes oder von Aenderungen des Lastwiderstandes (z.B. Schweissstrecke beim Punktschweissen) oder weiterer Aenderungen im Ladekreis, die während der Dauer eines Stromimpulses oder in den Impulspausen eintreten können. - Auch unter dem Gesichtspunkt der selbstgeführten Regelung ist eine hohe Eigenfrequenz des Entladekreises von Vorteil.

Bei der Schaltungsvariante nach Fig. 5 kann die Eingangsseite bis und mit dem Speicherkondensator z.B. wie nach Fig. 1 aufgebaut sein und ist nicht mehr dargestellt. Die Variante unterscheidet sich dadurch vom vorangehenden Beispiel, dass ein Transformator Tr' verwendet ist, dessen Primärwicklung eine Mittelanzapfung aufweist. Die beiden Hilfskondensatoren $C_1$, $C_2$ sind mit ihrem einen Pol an die Mittelanzapfung und mit dem anderen Pol über das jeweilige Entladesteuerorgan

$T_3$, $T_4$ an die entgegengesetzten Enden der Primärwicklungshälften angeschlossen. Wie durch Pfeile in Fig. 5 angedeutet, ist bei den abwechselnden Entladungen der Hilfskondensatoren die Stromrichtung auf der Primärseite und entsprechend auf der Sekundärseite jeweils entgegengesetzt, so dass Folgen von Teilimpulsen k mit alternierender Polarität erzeugt werden. Im Gegensatz zur Schaltung nach Fig. 1, mit der Gleichstromimpulse gebildet werden, erzeugt also die Variante nach Fig. 5 Wechselstromimpulse. Im übrigen gelten alle obenstehenden Ausführungen und Ueberlegungen, die zum Ausführungsbeispiel nach Fig. 1 angestellt worden sind, praktisch unverändert.

**Patentansprüche**

1. Elektrische Speiseschaltung zur Erzeugung von einzeln steuerbaren Stromimpulsen, insbesondere für die Widerstandsschweissung, mit einem Transformator (Tr), auf dessen Primärseite ein mit Gleichstrom gespeister, gesteuert auf- und entladbarer Speicherkondensator (C) vorhanden ist und dessen Sekundärkreis die Last (R) enthält, **gekennzeichnet** durch zwei zwischen den Speicherkondensator (C) und den Transformator (Tr) geschaltete Hilfskondensatoren ($C_1$, $C_2$) gleicher Kapazität, die über je ein Ladesteuerorgan ($T_1$, $T_2$) mit dem Speicherkondensator (C) und über je ein Entladesteuerorgan ($T_3$, $T_4$) mit der Primärseite des Transformators (Tr) verbunden sind, wobei die Kapazität des Speicherkondensators (C) ein Vielfaches derjenigen der Hilfskondensatoren ($C_1$, $C_2$) beträgt und wobei die letzteren mit der Induktivität des Entladekreises je einen Parallelschwingkreis bilden, ferner gekennzeichnet durch Steuermittel (2), die mit den Lade- und den Entladesteuerorganen ($T_1$, $T_2$, $T_3$, $T_4$) verbunden sind, um die beiden Hilfskondensatoren ($C_1$, $C_2$) abwechselnd und taktweise kontrolliert zu laden und zu entladen und dadurch dichte Folgen von Teilimpulsen (k) zu erzeugen, die, über den Transformator (Tr) übertragen, jeweils zusammen einen der zu erzeugenden Stromimpulse (K) bilden, wobei die Steuermittel (2) so gestaltet sind, dass die von ihnen bestimmte Taktfrequenz ($f_k$) der Teilimpulse (k) der Eigenfrequenz der genannten Schwingkreise entspricht.

2. Speiseschaltung nach Anspruch 1, dadurch gekennzeichnet, dass als Ladesteuerorgane Transistoren ($T_1$, $T_2$) verwendet sind.

3. Speiseschaltung nach Anspruch 1, dadurch gekennzeichnet, dass als Entladesteuerorgane Thyristoren oder Transistoren ($T_3$, $T_4$) verwendet sind.

4. Speiseschaltung nach Anspruch 1, dadurch gekennzeichnet, dass zwecks Bemessung der Schwingkreis-Eigenfrequenz eine Serieinduktivität ($L_z$) oder eine Parallelinduktivität ($L_p$) zum Transformator (Tr) zugeschaltet ist.

5. Speiseschaltung nach Anspruch 1, dadurch gekennzeichnet, dass die maximale Ladedauer der Hilfskondensatoren ($C_1$, $C_2$) etwas kürzer bemessen ist als die Halbperiodendauer ($t_k$) der Schwingkreis-Eigenschwingung.

6. Speiseschaltung nach Anspruch 1, dadurch gekennzeichnet, dass die Steuermittel (2) zur Vorgabe und Messung der Ladespannung der Hilfskondensatoren ($C_1$, $C_2$) eingerichtet sind.

7. Speiseschaltung nach Anspruch 1, dadurch gekennzeichnet, dass die Länge der Stromimpulse (K) durch Vorgabe der Anzahl Teilimpulse (k) an den Steuermitteln (2) einstellbar ist.

8. Speiseschaltung nach Anspruch 6, dadurch gekennzeichnet, dass der zeitliche Verlauf der Stromimpulse (K) durch Programmierung der maximalen Hilfskondensator-Ladespannung ($U_{C1}$, $U_{C2}$) und damit der Amplituden der einzelnen Teilimpulse (k) innerhalb der Teilimpuls-Folge bestimmbar ist.

9. Speiseschaltung nach einem der Ansprüche 1, 6 oder 8, dadurch gekennzeichnet, dass die Steuermittel (2) einen vom Sekundärkreis des Transformators (Tr) beeinflussten Istwert-Eingang (6) aufweisen und zur Durchführung eines Sollwert/Istwertvergleichs der Momentanwerte des Sekundärstroms der Teilimpulse (k) eingerichtet sind.

10. Speiseschaltung nach Anspruch 1, dadurch gekennzeichnet, dass die Steuermittel (2) einen Eingabeteil (3) und einen Steuerteil (4) aufweisen.

11. Speiseschaltung nach Anspruch 1, dadurch gekennzeichnet, dass die Schwingkreis-Parameter für gedämpfte, periodische Schwingungen ausgelegt sind, wobei jede Entladung eines der Hilfskondensatoren ($C_1$, $C_2$) die erste Halbwelle einer solchen Schwingung auslöst.

12. Speiseschaltung nach Anspruch 11, dadurch gekennzeichnet, dass zwecks selbstgeführter taktweiser Steuerung des Ladens und Entladens der Hilfskondensatoren ($C_1$, $C_2$) die Steuermittel (2) einen vom Sekundärkreis des Transformators (Tr) beeinflussten Steuereingang (6) aufweisen, welcher jeweils den Nulldurchgang am Ende der ersten Halbwelle feststellt.

13. Speiseschaltung nach einem der vorangehenden Ansprüche, dadurch gekennzeichnet, dass beide Hilfskondensatoren ($C_1$, $C_2$) über ihr jeweiliges Entladesteuerorgan ($T_3$, $T_4$) an das gleiche Ende einer einfachen Primärwicklung des Transformators (Tr) angeschlossen sind, um Folgen von Teilimpulsen (k) mit gleicher Polarität zu erzeugen.

14. Speiseschaltung nach einem der Ansprüche 1 bis 12, dadurch gekennzeichnet, dass der Transformator (Tr') eine Primärwicklung mit Mittelanzapfung aufweist und dass die beiden Hilfskondensatoren ($C_1$, $C_2$) mit dem einen Pol an die Mittelanzapfung und mit dem anderen Pol über ihr jeweiliges Entladesteuerorgan ($T_3$, $T_4$) an die entgegengesetzten Enden der beiden Primärwicklungshälften angeschlossen sind, um Folgen von Teilimpulsen (k) mit alternierender Polarität zu erzeugen.

**Claims**

1. Electrical supply circuit for the production of individually controllable current pulses, in particular for resistance welding, having a transformer (Tr) on whose primary side an energy storage capacitor (C), which is supplied with direct current and can be charged and discharged in a controlled manner, is present and whose secondary circuit contains the load (R), characterized by two auxiliary capacitors ($C_1$, $C_2$) which are connected between the energy storage capacitor (C) and the transformer (Tr), have the same capacitance and are connected via in each case one charge control device ($T_1$, $T_2$) to the energy storage capacitor (C) and via in each case one discharge control device ($T_3$, $T_4$) to the primary of the transformer (Tr), the capacitance of the energy storage capacitor (c) being a multiple of that of the auxiliary capacitors ($C_1$, $C_2$) and the latter in each case forming a parallel tuned circuit with the inductance of the discharge circuit, furthermore characterized by control means (2) which are connected to the charge and discharge control devices ($T_1$, $T_2$, $T_3$, $T_4$) in order to charge and to discharge the two auxiliary capacitors ($C_1$, $C_2$) alternately and cyclically in a controlled manner and in consequence to produce close sequences of partial pulses (k) which, transmitted via the transformer (Tr), in each case together form one of the current pulses (K) which is to be produced, the control means (2) being designed such that the clock frequency ($f_k$), which is determined by them, of the partial pulses (k) corresponds to the natural frequency of the said tuned circuits.

2. Supply circuit according to Claim 1, characterized in that transistors ($T_1$, $T_2$) are used as the charge control devices.

3. Supply circuit according to Claim 1, characterized in that thyristors or transistors ($T_3$, $T_4$) are used as the discharge control devices.

4. Supply circuit according to Claim 1, characterized in that a series inductance ($L_2$) or a parallel inductance

($L_p$) is connected to the transformer (Tr) in order to dimension the tuned circuit natural frequency.

5. Supply circuit according to Claim 1, characterized in that the maximum charging duration of the auxiliary capacitors ($C_1$, $C_2$) is dimensioned to be somewhat shorter than the half-cycle duration ($t_k$) of the tuned circuit natural oscillation.

6. Supply circuit according to Claim 1, characterized in that the control means (2) are set up in order to predetermine and measure the charge voltage of the auxiliary capacitors ($C_1$, $C_2$).

7. Supply circuit according to Claim 1, characterized in that the length of the current pulses (K) can be adjusted by predetermining the number of partial pulses (k) on the control means (2).

8. Supply circuit according to Claim 6, characterized in that the time profile of the current pulses (K) can be determined by programming the maximum auxiliary capacitor charge voltage ($U_{C1}$, $U_{C2}$) and thus the amplitudes of the individual partial pulses (k) within the partial pulse sequence.

9. Supply circuit according to one of Claims 1, 6 or 8, characterized in that the control means (2) have an actual value input (6) which is influenced by the secondary circuit of the transformer (Tr) and are set up in order to carry out a required value/actual value comparison of the instantaneous values of the secondary current of the partial pulses (k).

10. Supply circuit according to Claim 1, characterized in that the control means (2) have an input section (3) and a control section (4).

11. Supply circuit according to Claim 1, characterized in that the tuned circuit parameters are designed for damped, periodic oscillations, each discharge of one of the auxiliary capacitors ($C_1$, $C_2$) initiating the first half-cycle of such an oscillation.

12. Supply circuit according to Claim 11, characterized in that the control means (2) have a controlled input (6) for the purpose of self-commutated cyclic control of the charging and discharging of the auxiliary capacitors ($C_1$, $C_2$), which control input (6) is influenced by the secondary circuit of the transformer (Tr) and in each case detects the zero crossing at the end of the first half-cycle.

13. Supply circuit according to one of the preceding claims, characterized in that both auxiliary capacitors ($C_1$, $C_2$) are connected via their respective discharge control device ($T_3$, $T_4$) to the same end of a single primary winding of the transformer (Tr) in order to produce sequences of partial pulses (k) having the same polarity.

14. Supply circuit according to one of Claims 1 to 12, characterized in that the transformer (Tr') has a primary winding with a centre tap, and in that the two auxiliary capacitors ($C_1$, $C_2$) are connected by means of one of their terminals to the centre tap and by means of the other terminal via their respective discharge control device ($T_3$, $T_4$) to the opposite ends of the two primary winding halves in order to produce sequences of partial pulses (k) having alternating polarity.

## Revendications

1. Circuit d'alimentation électrique pour la production d'impulsions de courant commandables individuellement, notamment pour le soudage par résistance, comportant un transformateur (Tr), sur le côté primaire duquel est présent un condensateur d'accumulation (C), qui est alimenté par un courant continu et peut être chargé et déchargé d'une manière commandée et dont le circuit secondaire contient la charge (R),
caractérisé par deux condensateurs auxiliaires ($C_1$, $C_2$) de même capacité, qui sont branchés entre le condensateur accumulateur (C) et le transformateur (Tr) et qui sont reliés par l'intermédiaire d'organes respectifs de commande de charge ($T_1$, $T_2$) au condensateur accumulateur (C) et par l'intermédiaire d'organes respectifs de commande de décharge ($T_3$, $T_4$) au côté primaire du transformateur (Tr), la capacité du condensateur accumulateur (C) étant égale à un multiple de celle des condensateurs auxiliaires ($C_1$, $C_2$), et ces derniers formant chacun, avec l'inductance du circuit de décharge, un circuit oscillant parallèle, et caractérisé en outre par dos moyens de commande (2), qui sont reliés aux organes de commande de charge et de décharge ($T_1$, $T_2$, $T_3$, $T_4$), de manière à charger et à décharger d'une manière contrôlée alternativement et de façon cadencée les deux condensateurs auxiliaires ($C_1$, $C_2$) et produire de ce fait des suites denses d'impulsions partielles (k), qui, transmises par l'intermédiaire du transformateur (Tr), forment respectivement conjointement l'une des impulsions de courant (K) devant être produites, les moyens de commande (2) étant agencés de telle sorte que la fréquence de cadence ($f_k$), qui est déterminée par ces moyens de commande, des impulsions partielles (k) correspond à la fréquence propre desdits circuits oscillants.

2. Circuit d'alimentation selon la revendication 1, caractérisé en ce qu'on utilise des transistors ($T_1$, $T_2$) comme organes de commande de charge.

3. Circuit d'alimentation selon la revendication 1, caractérisé en ce qu'on utilise des thyristors ou des transistors ($T_3$, $T_4$) en tant qu'organes de commande de décharge.

4. Circuit d'alimentation selon la revendication 1, caractérisé en ce que pour le dimensionnement de la fréquence propre du circuit oscillant, une inductance série ($L_z$) ou une inductance parallèle ($L_p$) est branchée avec le transformateur (Tr).

5. Circuit d'alimentation selon la revendication 1, caractérisé en ce que la durée de charge maximale des condensateurs auxiliaires ($C_1$, $C_2$) est dimensionnée à une valeur légèrement inférieure à la durée ($t_k$) de l'alternance de l'oscillation propre du circuit oscillant.

6. Circuit d'alimentation selon la revendication 1, caractérisé en ce que les moyens de commande (2) sont agencés de manière à prédéterminer et mesurer la tension de charge des condensateurs auxiliaires ($C_1$, $C_2$).

7. Circuit d'alimentation selon la revendication 1, caractérisé en ce que la longueur des impulsions de courant (K) est réglable au moyen de la prédétermination du nombre des impulsions partielles (k), dans les moyens de commande (2).

8. Circuit d'alimentation selon la revendication 6, caractérisé en ce que la variation dans le temps des impulsions de courant (K) peut être déterminée par programmation de la tension de charge maximale ($U_{C1}$, $U_{C2}$) des condensateurs auxiliaires et par conséquent des amplitudes des impulsions partielles individuelles (k) à l'intérieur de la suite d'impulsions partielles.

9. Circuit d'alimentation selon l'une des revendications 1, 6 ou 8, caractérisé en ce que les moyens de commande (2) possèdent une entrée de valeur réelle (6), influencée par le circuit secondaire du transformateur (Tr), et sont agencés pour exécuter une comparaison valeur de consigne/valeur réelle des valeurs instantanées du courant secondaire des impulsions partielles (k).

10. Circuit d'alimentation selon la revendication 1, caractérisé en ce que les moyens de commande (2) possèdent une partie d'entrée (3) et une partie de commande (4).

11. Circuit d'alimentation selon la revendication 1, caractérisé par le fait que les paramètres du circuit oscillant sont conçus pour des oscillations périodiques amorties, chaque décharge de l'un des condensateurs auxiliaires ($C_1$, $C_2$) déclenchant la première alternance d'une telle oscillation.

12. Circuit d'alimentation selon la revendication 11, caractérisé en ce que pour obtenir une commande cadencée auto-pilotée de la charge et de la décharge des condensateurs auxiliaires ($C_1$, $C_2$), les moyens de commande (2) possèdent une entrée de commande (6) qui est influencée pour le circuit secondaire du transformateur (Tr) et qui détermine respectivement le passage par zéro à la fin de la première alternance.

13. Circuit d'alimentation selon l'une des revendications précédentes, caractérisé en ce que les deux condensateurs auxiliaires ($C_1$, $C_2$) sont raccordés, par l'intermédiaire de leur organe respectif de commande de décharge ($T_3$, $T_4$), à la même extrémité d'un enroulement primaire simple du transformateur (Tr), pour produire des suites d'impulsions partielles (k) de même polarité.

14. Circuit d'alimentation selon l'une des revendications 1 à 12, caractérisé en ce que le transformateur (Tr') possède un enroulement primaire à prise médiane et que les deux condensateurs auxiliaires ($C_1$, $C_2$) sont raccordés par un pôle à la prise médiane et par l'autre pôle, par l'intermédiaire de leur organe respectif de commande de décharge ($T_3$, $T_4$), aux extrémités opposées des deux moitiés de l'enroulement primaire, pour produire des suites d'impulsions partielles (k) ayant des polarités alternées.

## FIG.1

## FIG. 2

## FIG. 3

FIG. 4

FIG. 5